# EUROPEAN PATENT SPECIFICATION

(11) **EP 1 770 772 B1**
(45) Date of publication and mention of the grant of the patent: **18.07.2012**
(21) Application number: 05425681.3
(22) Date of filing: 30.09.2005
(51) Int. Cl.: H01L 21/8247, H01L 27/115, H01L 27/105

(54) **Process for manufacturing a non-volatile memory device**
Verfahren zur Herstellung einer nichtflüchtigen Speichervorrichtung
Procédé de fabrication d'un dispositif de mémoire non-volatile

(43) Date of publication of application: 04.04.2007
(73) Proprietor: STMicroelectronics Srl, 20864 Agrate Brianza (IT)
(72) Inventor: Pividori, Luca, I - 24035 Curno (Bergamo) (IT); Crippa, Claudio, I - 20049 Concorezzo (Milano) (IT)
(74) Representative: Niederkofler, Oswald

(56) References cited:
- US-A1- 2002 033 516
- US-A1- 2002 110 973
- US-A1- 2005 186 803
- US-B1- 6 207 509
- US-B1- 6 235 585
- US-B1- 6 458 655
- US-B1- 6 509 232
- US-B1- 6 689 653

## Description

### Field of application

The present invention relates to a process for manufacturing a non volatile memory device.

More specifically, the invention relates to a process for manufacturing a non volatile memory integrated on semiconductor substrate device comprising one matrix of memory cells with an associated circuitry, the process comprising the steps of:
- forming, in said semiconductor substrate, dielectric insulation regions of said matrix so as to define and insulate the active areas of said matrix from each another,
- forming, in said semiconductor substrate, dielectric insulation regions of said circuitry so as to define and insulate the active areas of said circuitry from each other,
- forming at least one first dielectric layer on said active areas,
- depositing a first conductive layer on the whole said device,
- defining floating gate electrodes of said memory cells of said matrix in said first conductive layer,
- removing, at least partially, said first conductive layer from the circuitry.

The invention particularly, but not exclusively, relates to a process for manufacturing memory devices of the Flash type and the following description is made with reference to this field of application by way of illustration only.

### Prior art

As it is well known, non volatile memory electronic devices integrated on semiconductor substrate, for example of the Flash type, comprise a plurality of non volatile memory cells organised in a matrix.

Each single non volatile memory cell comprises a MOS transistor wherein the gate electrode, placed above the channel region, is floating, i.e. it has a high impedance in DC towards all the other terminals of the same cell and of the circuit wherein the cell is inserted.

The cell also comprises a second electrode, called control gate, which is capacitively coupled to the floating gate electrode through a intermediate dielectric layer, so called interpoly. This second electrode is driven through suitable control voltages. The other electrodes of the transistor are the usual drain, source terminals.

The matrix of memory cells is associated with a control circuitry comprising at least one conventional MOS transistor comprising a source region and a drain region separated by a channel region. A gate electrode is then formed on the channel region and insulated therefrom by means of a gate oxide layer.

Each electronic component realising the memory electronic device is generally realised in a respective active area which is insulated from the adjacent one by means of dielectric insulation regions realised in the semiconductor substrate.

The presence of dielectric insulation regions is one of the main sources of displacement, i.e. crystallographic faults, which are created inside silicon semiconductor substrates wherein these non volatile memory devices are realised.

The presence of these displacements is particularly evident when the dielectric insulation regions are realised by means of STI (Shallow Trench Isolation).

The manufacturing steps to form a non volatile memory device comprises a matrix of memory cells and a corresponding circuitry, wherein the dielectric insulation regions have been realised by means of STI, comprise for example:
- forming sacrificial dielectric layers, comprising for example an oxide layer called PADOX (Pad-OXide) and if necessary a silicon nitride layer, on the whole semiconductor substrate,
- defining active areas for the circuitry and for the memory matrix by means of a conventional photolithographic technique which provides the formation of a photolithographic mask on the semiconductor substrate, wherein openings are defined,
- removing portions of the sacrificial dielectric layers and of the semiconductor substrate through these openings, by means of chemical etching for example of the dry type, so as to form trenches inside the semiconductor substrate itself,
- deposition through CVD (Chemical Vapor Deposition) or HDPCVD (High Density Plasma CVD) of a dielectric layer which has the aim of filling the trenches, after having removed the photolithographic mask,
- planarising the device by means of CMP (Chemical Mechanical Polishing),
- if necessary deposition of further sacrificial layers, for example called SAROX (Sacrificial Oxide).

The shape and the characteristics of the trenches which are realised through the deposition in plasma are thus very important. In fact the depth of the trenches, their shape, the transversal dimensions, the roughness of the various surfaces have great implications on a lot of parameters: the efficiency of the electric insulation, the quality of the active area, the presence or not of the crystallographic displacements.

A conventional process for manufacturing a non volatile memory device further comprises the steps of:
- removal of the sacrificial layers from the active areas of the memory matrix by means of suitable etching for example of the wet or dry type so as to expose the semiconductor substrate inside these active areas of the memory matrix,
- forming an active oxide layer also known as tunnel oxide in the active areas, for example by means of a thermal oxidation layer;
- depositing a first conductive layer, for example of polysilicon, on the whole device;
- defining floating gate electrodes in the matrix region a first polysilicon layer and elimination thereof from the circuitry;
- depositing a dielectric layer called of interpoly, for example ONO (Oxide Nitrate Oxide);
- forming a photolithographic mask called MATRIX on the matrix of memory cells, so as to shield the matrix, to eliminate, by means of chemical and physical etching, the interpoly layer and other possible oxide layers present in the circuitry;
- forming one or more dielectric layers, for example gate active oxide layers in the circuitry and in the memory matrix by means of a thermal oxidation step;
- depositing a second conductive layer, for example of polysilicon;
- defining the control gate electrodes of the matrix cells and the gate electrodes of the circuitry transistors in the second polysilicon layer;
- forming the source and drain regions of the matrix cells, of the transistors and of the metallisation layers.

Although advantageous under several aspects, this first solution has the drawback of generating stresses inside the insulation regions mainly due to the steps of:
- formation of the trenches in the semiconductor substrate,
- filling of the trenches with an oxide layer through CVD,
- carrying out thermal oxidation steps.

US 6,235,585 B1 is concerned with a method for fabricating a flash memory device including respectively forming a tunnelling oxide film and a peripheral oxide film on a cell and peripheral areas of a semiconductor substrate; forming a floating gate line on the tunnelling oxide film; forming a first insulating film on a surface of the floating gate line; forming second and third insulating films on an entire surface of the substrate; removing the third insulating film and the second insulating film from the peripheral area by wet etching processes; removing the peripheral oxide film by a wet etching process; forming a gate insulating film on the surface of the semiconductor substrate in the peripheral area; depositing a conductive layer on the entire surface of the semiconductor substrate; selectively removing portions of the conductive layer, the third, second and first insulating films and the floating gate line to form a control gate and a floating gate in the cell area and a gate electrode of a thin film transistor in the peripheral area.

US 2005/0186803 A1 relates to a method of manufacturing a semiconductor device including selectively forming a photoresist film on an insulating film formed on a surface of an underlying semiconductor region such that the photoresist provides a masked surface region and an exposed surface region for the insulating film, and selectively removing that portion of the insulating film which corresponds to the exposed surface region to expose the underlying semiconductor region.

US 6,689,653 B1 refers to methods of protecting the oxidized silicon nitride component of an oxidized silicon nitride on silicon oxide layer of a non-volatile memory device during the hydrofluoric, acid type procedures used for peripheral devices simultaneously fabricated with the non-volatile memory device.

US 6,207,509 B1 describes a method of manufacturing a semiconductor device, in which a first sacrifice oxide film is formed on a substrate. Next, a second sacrifice oxide film is formed on the substrate by etching the first sacrifice oxide film to a predetermined depth in a first etching process. Subsequently, the second sacrifice oxide film is removed from a surface of the substrate in a second etching process. Finally, an oxide film is formed on the exposed surface of the substrate.

US 6,458,655 B1 concerns a semiconductor manufacturing method including successively forming an insulation film and a conductive layer on a semiconductor substrate. On the conductive layer a patterned resist is formed. With the patterned resist used as a mask, the conductive layer is dry-etched. A surface layer of the patterned resist is partially removed. With the patterned resist used as a mask, the insulation film is wet-etched.

US 2002/0033516 A1 refers to a shallow trench isolation type semiconductor device including a gate insulating layer formed in first and second regions. The gate insulating layer is of greater thickness in the first region, relative to the thickness of the gate insulating layer in the second region. A shallow trench isolation layer is also formed in the first and second regions, the shallow trench isolation layer in the first region being thinner than the shallow trench isolation layer in the second region.

The technical problem underlying the present invention is that of providing a method to reduce the stress induced in the areas of the circuitry of the memory device through a process which ensures a flexibility of intervention not allowed by the methods generally used and known.

### Summary of the invention

The solution idea underlying the present invention is that of introducing, in the standard process flow for manufacturing a non volatile memory electronic device, a partial etching step of the dielectric layers present on the non volatile memory electronic device, immediately after the definition of the floating gate electrodes.

On the basis of this solution idea the technical problem is solved by a method as previously indicated and defined by the characterising part of claim 1.

The characteristics and advantages of the device according to the invention will be apparent from the following description of an embodiment thereof given by way of indicative and non limiting example with reference to the annexed drawings.

### Brief description of the drawings

In these drawings:
- figures 1 to 6 are respective schematic section views of a portion of integrated circuit during the successive steps of a process according to the present invention,
- figure 7 shows an enlarged detail of a portion of integrated circuit.

### Detailed description

The process steps described hereafter do not form a complete process flow for manufacturing integrated circuits. The present invention can be put into practice together with the manufacturing techniques of the integrated circuits currently used in the field, and only those process steps being commonly used in the field and necessary for the comprehension of the present invention are included.

The figures showing cross sections of portions of an integrated circuit during the manufacturing are not drawn to scale, but they are instead drawn so as to show the important characteristics of the invention.

With reference to the figures, a process is described for manufacturing a non volatile memory device 1 integrated on semiconductor substrate 2, which comprises a matrix 3 of non volatile memory cells and an associated circuitry 4.

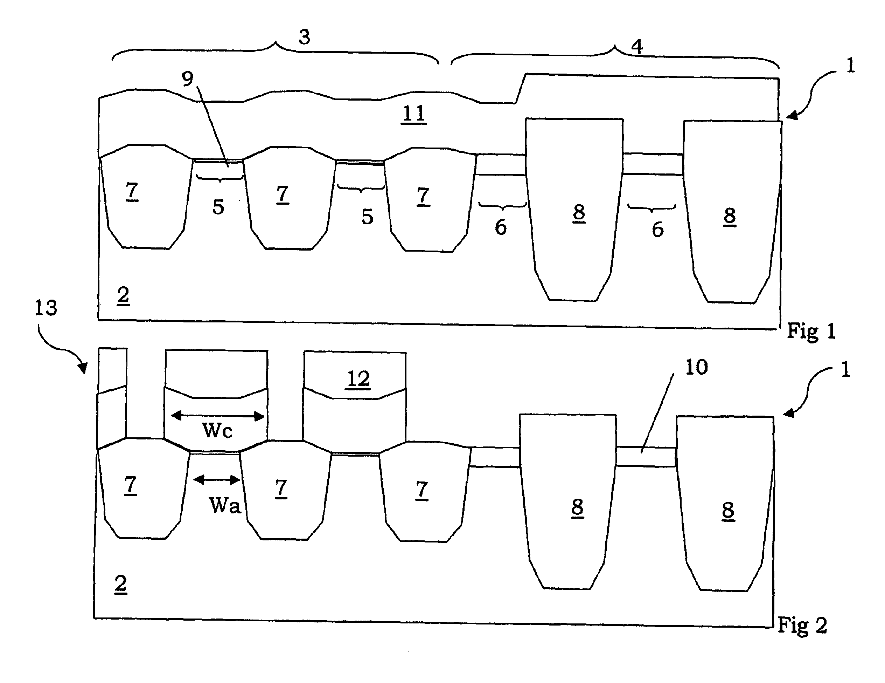

With particular reference to figure 1, on the semiconductor substrate 2 sacrificial dielectric layers 10 are formed, if necessary, comprising for example an oxide layer called PADOX (Pad-OXide).

In the semiconductor substrate 2, dielectric insulation regions 7 the matrix 3 are then formed which define and insulate from each other active areas 5 of the matrix 3 and dielectric insulation regions 8 of the circuitry 4 which define and insulate from each other active areas 6 of the circuitry 4.

These dielectric insulation regions 7, 8 are formed by a dielectric layer, for example by a field oxide layer, and they are for example of the STI type, then realised as described with reference to the prior art.

Moreover the dielectric insulation regions 8 of the circuitry 4 can be deeper in the semiconductor substrate 2 than in the dielectric insulation regions 7 of the matrix 3, and have a greater height of the insulation regions 7 of the matrix 3 with respect to the surface of the semiconductor substrate 2.

Once the sacrificial dielectric layers 10, if present, are removed from the active areas 5 of the matrix 3, the process for manufacturing a non volatile memory device 1 then goes on with the formation of a dielectric layer 9, for example a tunnel oxide layer on the whole device 1.

In particular, in the matrix 3 of memory cells this tunnel oxide layer 9 is formed directly on the semiconductor substrate 2, while in the circuitry 4 this layer is overlapped onto sacrificial dielectric layers 10 if already present in the circuitry 4.

The process then goes on by means of deposition of a first conductive layer 11 for example of polysilicon on the whole device 1.

As shown in figure 2, a first photolithographic mask 12 is then formed on the semiconductor substrate 2, wherein openings are defined. Through these openings, by means of etching for example of the dry type, portions of the first polysilicon layer 11 are removed so as to define floating gate electrodes 13 in the region of the matrix 3 and to completely eliminate this first polysilicon layer 11 from the circuitry 4.

Nothing forbids that portions of this first polysilicon layer 11 can remain inside the circuitry 4.

Advantageously, the floating gate electrodes 13 in the region of the matrix 3 have a first width Wc greater than a second width Wa of the active areas 5 of the matrix 3.

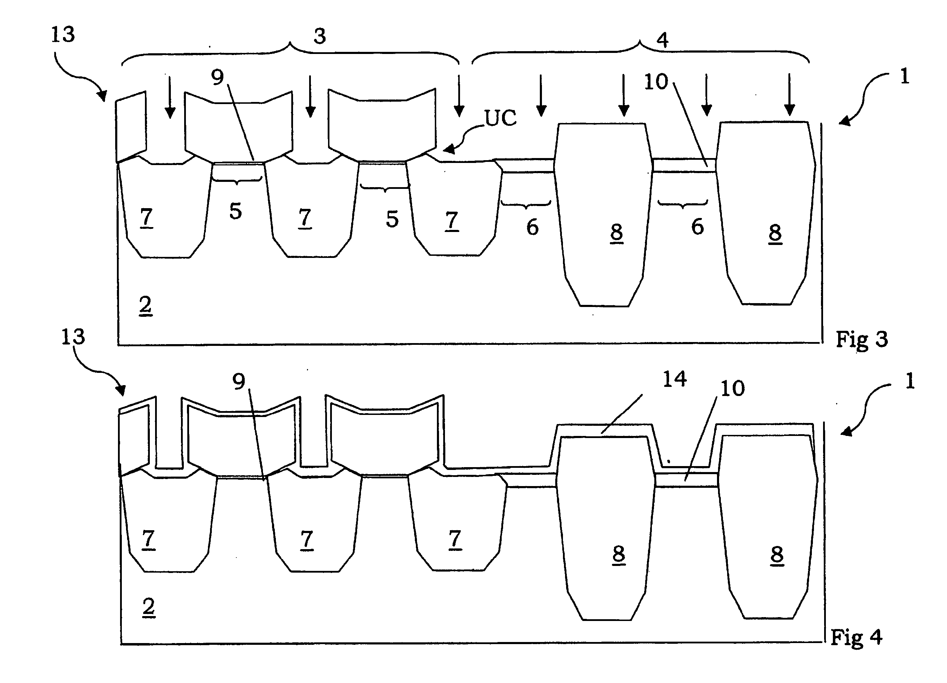

Once the first photolithographic mask 12 is removed, according to the invention, a blanket etching step is carried out i.e. without the help of a lithographic masking and it thus etches all the structures of the device both in matrix and in circuitry, for removing a surface portion of the dielectric insulation regions 7, 8 and of the sacrificial dielectric layers 10 not shielded by the floating gate electrodes 13, as shown in figure 3.

In particular, this etching step removes a surface portion of the insulation regions 7 of the matrix 3, of the insulation regions 8 of the circuitry 4 and of the sacrificial dielectric layers 10 if present in circuitry 4, as well as the tunnel oxide layer 9 present in circuitry 4. In particular if the sacrificial layers 10 are not present in the circuitry 4 only the tunnel oxide layer 9 tunnel is removed, completely or at least partially.

In particular, this blanket etching step must be such as not expose the active areas 5 present in matrix 3 and thus etch the tunnel oxide layer 9 present in matrix 3.

Advantageously according to the invention, the blanket etching step is of the isotropic type, and it is realised for example by means of BOE (Buffered Oxide Etch) in wet.

By carrying out this blanket etching step of the isotropic type, also portions of the insulation regions 7 are removed which are below the floating gate electrode 13, whereby a small trench UC is located below the floating gate electrodes on bottom of the wall of the first polysilicon conductive layer.

By means of a blanket etching step of the BOE type, for example, a surface portion of the exposed dielectric layers whose thickness is comprised in a range 50Å to 300 Å (5-30 nm) is removed.

Nothing forbids that however the blanket etching step, according to the invention, is of the anisotropic type, for example of the dry type in plasma.

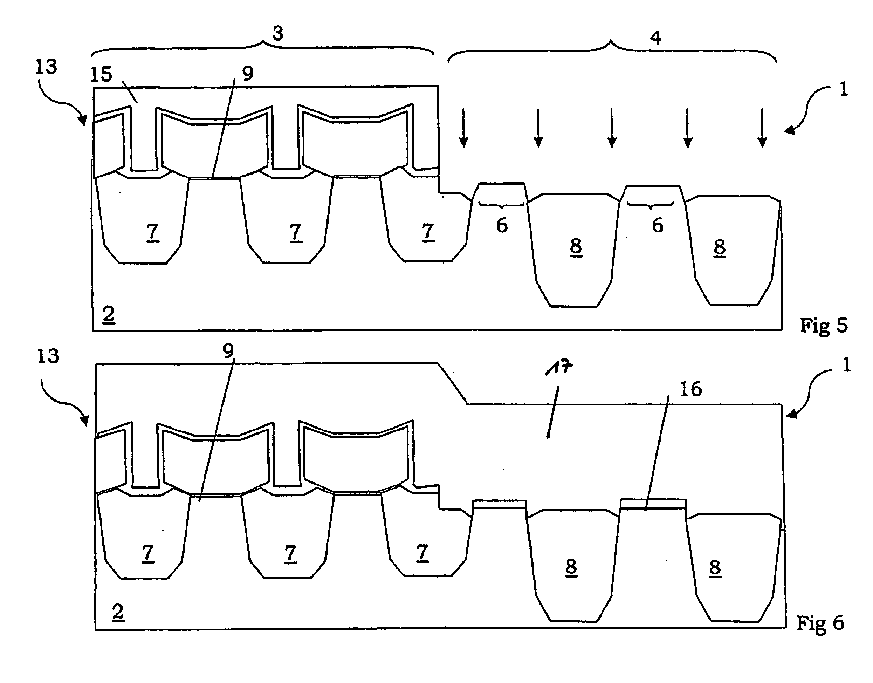

The manufacturing process of the memory device 1 then goes on with the conventional process steps comprising:
- depositing a dielectric layer 14 called of interpoly, for example ONO (Oxide Nitrate Oxide) on the whole device, as shown in figure 4;
- forming a second photolithographic mask 15, called MATRIX mask on the memory matrix 3, and etching the interpoly dielectric layer 14 and other oxide layers 10, if present, in the circuitry 4, until the active areas of the circuitry 4 are exposed. As shown in figure 5, this latter etching step of the interpoly dielectric layer 14 and ,if present, of the other oxide layers 10 also removes a further surface portion of the insulation regions 8 of the circuitry 4.

Advantageously, this etching step provides a first etching step of the interpoly dielectric layer 14 by means of an etching of the anisotropic type and a second isotropic etching step of the oxide layers 10 of the circuitry 4, for example by using a solution of the BOE type.

As shown in figure 6, the process for manufacturing a non volatile memory device 1 also comprises the steps of:
- forming one or more dielectric layers 16, for example gate active oxides, in the circuitry 4, for example by means of a thermal oxidation step. Clearly, this latter thermal oxidation step also interests the matrix; however the presence of the dielectric layer 14 prevents the growth of these oxides in matrix and their effect is to densify the dielectric layer 14 itself improving its performances,
- depositing a second conductive layer 17 for example of polysilicon.

Then control gate electrodes of the matrix 3 cells and gate electrodes of transistors of the circuitry 4 are defined in the second polysilicon layer 17, the source and drain regions of the transistors and the metallisation layers are realised in a conventional way.

According to the invention then in the conventional process flow for the manufacturing of memory devices, a supplementary blanket etching step is added to remove a surface portion of the insulation regions 7, 8 and of the dielectric sacrificial layers 10 not shielded by the floating gate electrodes 13 before the formation of the interpoly dielectric layer 14.

Advantageously, during this blanket etching step in matrix 3 there are no critical areas which could be damaged by the etching and thus, in circuitry, the removal of parts of the sacrificial dielectric layers 10 on the active areas is provided. These oxide layers 10 must be in fact completely removed before proceeding with the formation of one or more gate oxide layers in circuitry.

Still advantageously according to the invention, introducing this supplementary blanket etching step also allows to minimise the arise of unsticking problems of the resist layer the mask 15 matrix is generally made of. This unsticking phenomenon, due to the etching step conventionally used to "clean" the circuitry of the sacrificial dielectric layers, shows itself in particular when lithographic resists of the DUV type are used, which are by now conventional for the manufacturing of semiconductor memory devices with sizes smaller than 0.13µm, and it occurs in particular when these resist layers are subjected to very long isotropic etchings, for example BOE in wet, i.e. etchings which remove equivalent thermal oxide layers with thickness greater than 500 Å. Thus, by introducing the supplementary blanket etching step according to the invention it is possible to increase the thickness of the removed layers with respect to the one obtained with a single conventional etching step, which is carried out after the formation of the matrix mask 15, without jeopardising the performance of the materials used.

Moreover it is known that during the planarisation operations used for manufacturing the insulation regions of the STI type realised by means of CMP, on these insulation regions micro-scratches can be formed which are filled by the polysilicon layer 11 subsequently formed on the device 1. However during the successive definition step of the floating gate electrodes 13, polysilicon residues remain incorporated in the micro-scratches.

These polysilicon residues, even if they are minimal and not able to generate real short circuits between two floating gates, can represent however a possible problem of reliability for memory devices, in particular of the multilevel Flash type; in fact the polysilicon residue incorporated in the micro-scratch is a preferential path for the electrical charges which may in this way go out of a cell and pass to the adjacent one generating the flip-bit (charge exchange) phenomenon with subsequent loss of the information previously stored in the single memory cell. The blanket etching step, according to the invention, in fact allows to eliminate the polysilicon residue present in the micro-scratch, eliminating the portion of insulation region, i.e. of the field oxide layer surrounding it.

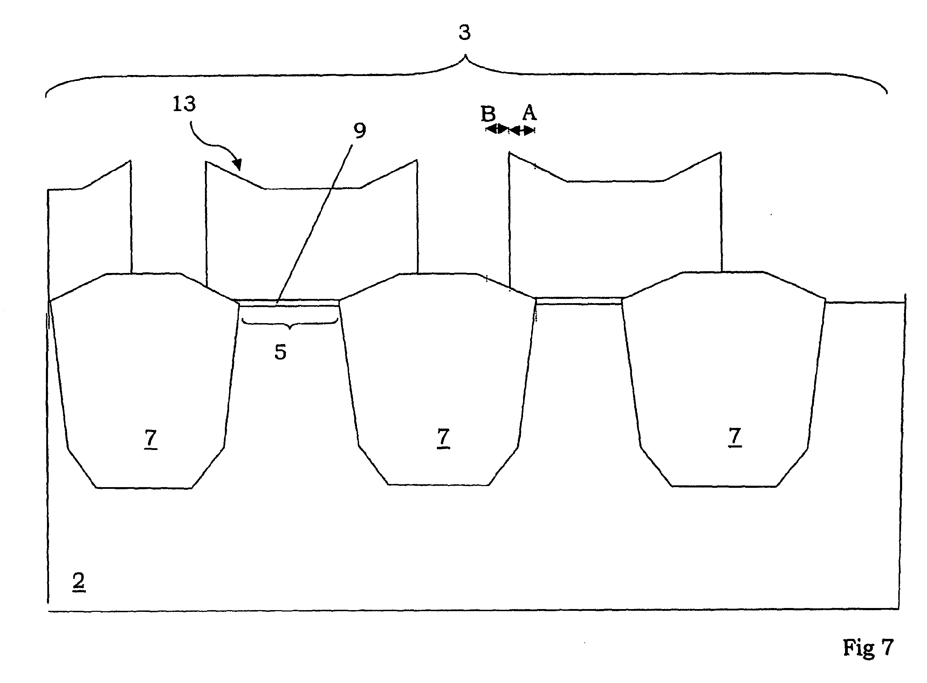

Advantageously according to the invention, as shown in figure 7, when evaluating the time range wherein the supplementary blanket etching is to be carried out according to the invention what follows is taken into consideration:
- the distance A between the side wall of the floating gate electrode 13 and the edge of the active area 5 wherein these electrodes are defined and formed,
- the overlay specifications relative to the technology and/or to the product, which determined the possible extent of a misalignment, indicated with the distance B, of the floating gate electrode 13 with respect to the active area 5.

From the evaluation of these parameters it is possible to determine the maximum time possible to carry out the blanket etching without incurring an infiltration of the etching solution which can go and etch also the tunnel oxide dielectric layer 9 of the cell.

Advantageously, if the blanket etching is of the isotropic type the devices realised with this method can be clearly identified by means of a simple SEM section in the region of the matrix cells, where the characteristic morphology with undercut caused by the blanket etching carried out before the deposition of the interpoly dielectric layer is present.

Moreover, for flash memories the blanket etching according to the invention in fact allows to lower the insulation regions 8 improving the morphology of the interface portion between insulation regions 8 and active areas. The quality of the oxide layers which will be after formed, and the stress release and thus the reduction of the formations of displacements are improved.

Although in the description particular reference has been made to a process for manufacturing a two-level non volatile memory device the process according to the invention can be advantageously applied to multilevel non volatile memory devices.

## Claims

1. Process for manufacturing a non volatile memory device (1) integrated on a semiconductor substrate (2) comprising a matrix (3) of memory cells with an associated circuitry (4), the process comprising the steps of:
- forming in said semiconductor substrate (2) dielectric insulation regions (7) of said matrix (3) so as to define and insulate from each other the active areas (5) of said matrix (3),
- forming in said semiconductor substrate (2) dielectric insulation regions (8) of said circuitry (4) so as to define and insulate from each other active areas (6) of said circuitry (4),
- forming at least one first dielectric layer (9) on said active areas (5, 6),
- depositing a first conductive layer (11) on the whole device (1),
- defining floating gate electrodes (13) of said memory cells of said matrix (3) in said first conductive layer (11),
- removing at least partially said first conductive layer (11) from the circuitry (4),
the process being **characterised in that** it comprises the steps of: ;
- carrying out a blanket etching on the whole device (1) to remove a surface portion of said dielectric insulation regions (7, 8) not shielded by said floating gate electrodes (13), said floating gate electrodes (13) having a first width (Wc) greater than a second width (Wa) of said active areas (5) of said matrix.

2. Process according to claim 1, comprising the steps of:
- forming at least one sacrificial dielectric layer (10) before the formation step in said semiconductor substrate (2) of said dielectric insulation regions (7, 8),
- removing said at least one dielectric layer (10) from said active areas (5) of said matrix (3), **characterised in that** a surface portion of said at least one sacrificial dielectric layer (10) is also removed during the blanket etching step.

3. Process according to claim 1, **characterised in that** said blanket etching step is of the isotropic type.

4. Process according to claim 1, **characterised in that** said blanket etching step is realised by means of Buffered Oxide Etch in wet.

5. Process according to claim 3, **characterised in that** said blanket etching step also removes portions of said insulation regions (7) of said matrix (3) which are below said floating gate electrode (13).

6. Process according to claim 1, **characterised in that** said blanket etching step is of the anisotropic type.

7. Process according to claim 6, **characterised in that** said blanket etching step is of the dry type in plasma.

8. Process according to claim 1, **characterised in that** said blanket etching step removes surface portions of said dielectric insulation regions (7, 8), said surface portions having a thickness comprised in a range from 5 nm to 30 nm.

9. Process according to claim 1, **characterised in that** said dielectric insulation regions (7, 8) are of the STI type.

10. Process according to claim 9, **characterised in that** said dielectric insulation regions (7, 8) are formed by means of the steps of:
- forming trenches inside the semiconductor substrate (2),
- deposition through Chemical Vapor Deposition of a dielectric layer to fill said trenches,
- planarising the surface of the device (1) by means of Chemical Mechanical Polishing.

11. Process according to claim 1, **characterised in that** said dielectric insulation regions (8) of said circuitry (4) are deeper in the semiconductor substrate (2) with respect to said insulation regions (7) of said matrix (3).

12. Process according to claim 1, **characterised in that**, before carrying out said blanket etching step, said dielectric insulation regions (8) of said circuitry (4) have a greater height than said insulation regions (7) of said matrix (3) with respect to the surface of said semiconductor substrate (2).

13. Process according to claim 1, **characterised in that** it comprises the further steps of:
- depositing an interpoly dielectric layer (14) on the whole device (1);
- forming a second photolithographic mask (15) on the matrix (3),
- etching said interpoly dielectric layer (14) and if present other oxide layers (10) present in said circuitry (4); until the active areas (8) of said circuitry (4) are exposed,
- forming one or more dielectric layers (16) in the circuitry (4) and in the matrix (3);
- depositing a second conductive polysilicon layer (17),
- defining control gate electrodes of said cells of said matrix (3) and gate electrodes of transistors of said circuitry (4) in said second conductive polysilicon layer (17),
- forming source and drain regions of said memory cells (3) and of said transistors of said circuitry (4) and metallisation layers.

14. Process according to claim 13, **characterised in that** said first conductive layer is made of a polysilicon layer.

15. Process according to claim 1, **characterised in that** said dielectric insulation regions (7, 8) and said first dielectric layer (9) are made of an oxide layer.

## Patentansprüche

1. Verfahren zum Herstellen einer nicht flüchtigen Speichervorrichtung (1), die auf einem Halbleitersubstrat (2) integriert ist, die eine Matrix (3) aus Speicherzellen mit einer zugeordneten Schaltung (4) umfasst, wobei das Verfahren umfasst:
- Bilden dielektrischer Isolierregionen (7) der Matrix (3) in dem Halbleitersubstrat (2), um so die aktiven Bereiche (5) der Matrix (3) zu definieren und voneinander zu isolieren,
- Bilden dielektrischer Isolierregionen (8) der Schaltung (4) in dem Halbleitersubstrat (2), um so aktive Bereiche (6) der Schaltung (4) zu definieren und voneinander zu isolieren,
- Bilden wenigstens einer dielektrischen Schicht (9) auf den aktiven Bereichen (5, 6),
- Abscheiden einer ersten leitenden Schicht (11) auf der gesamten Vorrichtung (1),
- Definieren von Floating-Gate-Elektroden (13) der Speicherzellen der Matrix (3) in der ersten leitenden Schicht (11),
- Entfernen wenigstens zum Teil der ersten leitenden Schicht (11) von der Schaltung (4), wobei das Verfahren **dadurch gekennzeichnet ist, dass** es umfasst:
- Ausführen eines maskenlosen Ätzens auf der gesamten Vorrichtung (1), um einen Oberflächenteil der dielektrischen Isolierungsregionen (7, 8) zu entfernen, die nicht durch die Floating-Gate-Elektroden (13) abgeschirmt sind, wobei die Floating-Gate-Elektroden (13) eine erste Breite (Wc) aufweisen, die größer ist als eine zweite Breite (Wa) der aktiven Bereiche (5) der Matrix.

2. Verfahren nach Anspruch 1, umfassend:
- Bilden wenigstens einer dielektrischen Opferschicht (10), bevor in dem Halbleitersubstrat (2) die dielektrischen Isolierregionen (7, 8) gebildet werden,
- Entfernen der wenigstens einen dielektrischen Schicht (10) von den aktiven Bereichen (5) der Matrix (3), **dadurch gekennzeichnet, dass** ein Oberflächenteil der wenigstens einen dielektrischen Opferschicht (10) ebenso während des maskenlosen Ätzens entfernt wird.

3. Verfahren nach Anspruch 1, **dadurch gekennzeichnet, dass** das maskenlose Ätzen isotrop ist.

4. Verfahren nach Anspruch 1, **dadurch gekennzeichnet, dass** das maskenlose Ätzen durch gepuffertes Oxid-Nassätzen verwirklicht wird.

5. Verfahren nach Anspruch 3, **dadurch gekennzeichnet, dass** das maskenlose Ätzen auch Teile der Isolierregionen (7) der Matrix (3) entfernt, die unter der Floating-Gate-Elektrode (13) sind.

6. Verfahren nach Anspruch 1, **dadurch gekennzeichnet, dass** das maskenlose Ätzen anisotrop ist.

7. Verfahren nach Anspruch 6, **dadurch gekennzeichnet, dass** das maskenlose Ätzen ein Trockenplasmaätzen ist.

8. Verfahren nach Anspruch 1, **dadurch gekennzeichnet, dass** das maskenlose Ätzen Oberflächenteile der dielektrischen Isolierregionen (7, 8) entfernt, wobei die Oberflächenteile eine Dicke aufweisen, die in einem Bereich von 5 nm bis 30 nm enthalten ist.

9. Verfahren nach Anspruch 1, **dadurch gekennzeichnet, dass** die dielektrischen Isolierregionen (7, 8) vom STI-Typ sind.

10. Verfahren nach Anspruch 9, **dadurch gekennzeichnet, dass** die dielektrischen Isolierregionen (7, 8) gebildet werden durch:
- Bilden von Gräben in dem Halbleitersubstrat (2),
- Abscheiden einer dielektrischen Schicht zum Füllen der Gräben durch chemische Gasphasenabscheidung,
- Planarisieren der Oberfläche der Vorrichtung (1) durch chemisch-mechanisches Polieren.

11. Verfahren nach Anspruch 1, **dadurch gekennzeichnet, dass** die dielektrischen Isolierregionen (8) der Schaltung (4) tiefer in dem Halbleitersubstrat (2) in Bezug auf die Isolierregionen (7) der Matrix (3) sind.

12. Verfahren nach Anspruch 1, **dadurch gekennzeichnet, dass** bevor das maskenlose Ätzen durchgeführt wird, die dielektrischen Isolierregionen (8) der Schaltung (4) eine größere Höhe aufweisen als die Isolierregionen (7) der Matrix (3) in Bezug auf die Oberfläche des Halbleitersubstrats (2).

13. Verfahren nach Anspruch 1, **dadurch gekennzeichnet, dass** es des Weiteren umfasst:
- Abscheiden einer interpoly-dielektrischen Schicht (14) auf der gesamten Vorrichtung (1);
- Bilden einer zweiten photolithographischen Maske (15) auf der Matrix (3),
- Ätzen der interpoly-dielektrischen Schicht (14) und wenn vorhanden, anderer Oxidschichten (10), die in der Schaltung (4) vorhanden sind, bis die aktiven Bereiche (8) der Schaltung (4) freigelegt sind,
- Bilden einer oder mehr dielektrischer Schichten (16) in der Schaltung (4) und in der Matrix (3);
- Abscheiden einer zweiten leitenden Polysiliziumschicht (17),
- Definieren von Steuer-Gate-Elektroden der Zellen der Matrix (3) und von Gate-Elektroden von Transistoren der Schaltung (4) in der zweiten leitfähigen Polysiliziumschicht (17),
- Bilden von Source- und Drain-Regionen der Speicherzellen (3) und der Transistoren der Schaltung (4) und von Metallisierungsschichten.

14. Verfahren nach Anspruch 13, **dadurch gekennzeichnet, dass** die erste leitende Schicht aus einer Polysiliziumschicht hergestellt ist.

15. Verfahren nach Anspruch 1, **dadurch gekennzeichnet, dass** die dielektrischen Isolierregionen (7, 8) und die erste dielektrische Schicht (9) aus einer Oxidschicht hergestellt sind.

## Revendications

1. Procédé de fabrication d'un dispositif de mémoire non-volatile (1) intégré sur un substrat semi-conducteur (2) comprenant une matrice (3) de cellules de mémoire avec un ensemble de circuits associé (4), le procédé comprenant les étapes consistant à :
- former dans ledit substrat semi-conducteur (2) des régions d'isolation diélectriques (7) de ladite matrice (3) de manière à définir et à isoler entre elles les zones actives (5) de ladite matrice (3),
- former dans ledit substrat semi-conducteur (2) des régions d'isolation diélectriques (8) dudit ensemble de circuits (4) de manière à définir et à isoler entre elles des zones actives (6) dudit ensemble de circuits (4),
- former au moins une première couche diélectrique (9) sur lesdites zones actives (5, 6),
- déposer une première couche conductrice (11) sur l'ensemble du dispositif (1),
- définir des électrodes de grille flottante (13) desdites cellules de mémoire de ladite matrice (3) dans ladite première couche conductrice (11),
- enlever au moins partiellement ladite première couche conductrice (11) de l'ensemble de circuits (4),
le procédé étant **caractérisé en ce qu'**il comprend les étapes consistant à :
- effectuer une gravure de couverture sur l'ensemble du dispositif (1) pour enlever une portion de surface desdites régions d'isolation diélectriques (7, 8) non protégées par lesdites électrodes de grille flottante (13), lesdites électrodes de grille flottante (13) ayant une première largeur (Wc) supérieure à une seconde largeur (Wa) desdites zones actives (5) de ladite matrice.

2. Procédé selon la revendication 1, comprenant les étapes consistant à :
- former au moins une couche diélectrique sacrificielle (10) avant l'étape de formation dans ledit substrat semi-conducteur (2) desdites régions d'isolation diélectriques (7, 8),
- enlever ladite au moins une couche diélectrique (10) desdites zones actives (5) de ladite matrice (3),
**caractérisé en ce qu'**une portion de surface de ladite au moins une couche diélectrique sacrificielle (10) est également enlevée pendant l'étape de gravure de couverture.

3. Procédé selon la revendication 1, **caractérisé en ce que** ladite étape de gravure de couverture est de type isotrope.

4. Procédé selon la revendication 1, **caractérisé en ce que** ladite étape de gravure de couverture est réalisée au moyen d'un oxyde gravant tamponné (BOE) par voie humide.

5. Procédé selon la revendication 3, **caractérisé en ce que** ladite étape de gravure de couverture enlève également des portions desdites régions d'isolation (7) de ladite matrice (3) qui sont en dessous de ladite électrode de grille flottante (13).

6. Procédé selon la revendication 1, **caractérisé en ce que** ladite étape de gravure de couverture est de type anisotrope.

7. Procédé selon la revendication 6, **caractérisé en ce que** ladite étape de gravure de couverture est de type par voie sèche au plasma.

8. Procédé selon la revendication 1, **caractérisé en ce que** ladite étape de gravure de couverture enlève des portions de surface desdites régions d'isolation diélectriques (7, 8), lesdites portions de surface ayant une épaisseur comprise dans une plage allant de 5 nm à 30 nm.

9. Procédé selon la revendication 1, **caractérisé en ce que** lesdites régions d'isolation diélectriques (7, 8) sont du type à tranchée peu profonde (STI).

10. Procédé selon la revendication 9, **caractérisé en ce que** lesdites régions d'isolation diélectriques (7, 8) sont formées au moyen des étapes consistant à :
- former des tranchées à l'intérieur du substrat semi-conducteur (2),
- déposer une couche diélectrique par dépôt chimique en phase vapeur pour remplir lesdites tranchées,
- aplanir la surface du dispositif (1) au moyen d'un polissage chimico-mécanique.

11. Procédé selon la revendication 1, **caractérisé en ce que** lesdites régions d'isolation diélectriques (8) dudit ensemble de circuits (4) sont plus profondes dans le substrat semi-conducteur (2) par rapport aux dites régions d'isolation (7) de ladite matrice (3).

12. Procédé selon la revendication 1, **caractérisé en ce que**, avant de réaliser ladite étape de gravure de couverture, lesdites régions d'isolation diélectriques (8) dudit ensemble de circuits (4) ont une hauteur plus grande que lesdites régions d'isolation (7) de ladite matrice (3) par rapport à la surface dudit substrat semi-conducteur (2).

13. Procédé selon la revendication 1, **caractérisé en ce qu'**il comprend les étapes supplémentaires consistant à :
- déposer une couche diélectrique interpoly (14) sur l'ensemble du dispositif (1) ;
- former un second masque photolithographique (15) sur la matrice (3),
- graver ladite couche diélectrique interpoly (14) et, si présentes, d'autres couches d'oxyde (10) présentes dans ledit ensemble de circuits (4), jusqu'à ce que les zones actives (8) dudit ensemble de circuits (4) soient exposées,
- former une ou plusieurs couches diélectriques (16) dans l'ensemble de circuits (4) et dans la matrice (3) ;
- déposer une seconde couche de polysilicium conductrice (17),
- définir des électrodes dites grilles de commande desdites cellules de ladite matrice (3) et des électrodes grilles des transistors dudit ensemble de circuits (4) dans ladite seconde couche de polysilicium conductrice (17),
- former des régions source et drain desdites cellules de mémoire (3) et desdits transistors dudit ensemble de circuits (4) et des couches de métallisation.

14. Procédé selon la revendication 13, **caractérisé en ce que** ladite première couche conductrice est constituée d'une couche de polysilicium.

15. Procédé selon la revendication 1, **caractérisé en ce que** lesdites régions d'isolation diélectriques (7, 8) et ladite première couche diélectrique (9) sont constituées d'une couche d'oxyde.
